Europäisches Patentamt

European Patent Office

Office européen des brevets

(19)

(11) Publication number: **0 160 403**
A2

(12)

# EUROPEAN PATENT APPLICATION

(21) Application number: **85302239.0**

(22) Date of filing: **01.04.85**

(51) Int. Cl.⁴: **H 01 L 21/208**
**C 30 B 19/02, H 01 L 29/207**
**C 30 B 19/10**

(30) Priority: **28.04.84 GB 8410930**

(43) Date of publication of application:
**06.11.85 Bulletin 85/45**

(84) Designated Contracting States:
**AT BE CH DE FR IT LI LU NL SE**

(71) Applicant: **STANDARD TELEPHONES AND CABLES PUBLIC LIMITED COMPANY**
**190 Strand**
**London, WC2R 1DU(GB)**

(72) Inventor: **Greene, Peter David**
**23, Old Orchard**
**Harlow Essex CM18 6YG(GB)**

(74) Representative: **Laurence, Simon French**
**STC Patent Department Edinburgh Way**
**Harlow Essex CM20 2SH(GB)**

(54) Growing high resistivity quaternary material by liquid phase epitaxy.

(57) Iron has too low a solubility to be a convenient dopant for producing high resistivity blocking material by liquid phase epitaxy in the construction of InP and InGaAsP semiconductor devices. Manganese is used in its stead in conjunction with a donor such as germanium to act as partial compensation in view of the fact that the acceptor level of manganese in InP is not as deep as that of iron.

EP 0 160 403 A2

Croydon Printing Company Ltd

P.D. Gr. 0160403

## GROWING HIGH RESISTIVITY QUATERNARY MATERIAL
## BY LIQUID PHASE EPITAXY

This invention relates to the growth of high resistivity blocking material for devices based on InP and $In_{1-x} Ga_x As_y P_{1-y}$ by liquid phase epitaxy.

In the construction of certain types of semiconductor device, particularly lasers, it can be advantageous to be able to grow regions of high resistivity blocking material whose function is to obstruct, the flow of current through paths that would otherwise shunt the region or regions where current flow is particularly desired. Typically, the current carrying parts of $In_{1-x} Ga_x As_y P_{1-y}$ devices have resistivities in the range $10^{-1}$ to $10^{-3}$ ohm cm, and, in comparison with this, material having resistivities in the range 2 to 100 ohm cm is effectively to be considered to be high resistivity material.

High resistivity InP or $In_{1-x} Ga_x As_y P_{1-y}$ can in principle be produced by eliminating substantially all impurities so as to produce intrinsic material, but this method of obtaining high resistivity material is not easy to use in practice for multilayer liquid phase epitaxy because of its susceptibility to contamination by dopants migrating from adjacent layers of deliberately doped material.

Alternatively high resistivity material can be produced by incorporating deep donors or deep acceptors into the material to pin the Fermi level near the middle of the band gap. In the production of bulk InP grown by the Czochralski crystal growth method at a temperature in the region of $1070^\circ$C it has been found that iron can be used for this purpose. However, the low solubility of iron is such a problem that iron is not effective in producing high resistivity material by liquid phase epitaxy for which the deposition temperature is much lower, being typically in the region of 600 to $680^\circ$C.

According to the present invention there is provided a method of semiconductor device manufacture including the step of growing high resistivity InP or $In_{1-x} Ga_x As_y P_{1-y}$ blocking material by liquid phase epitaxy, characterised in that the blocking material is doped with manganese together with a donor dopant or dopant mixture at a concentration providing partial compensation of the manganese doping.

The invention also resides in a semiconductor device incorporating one or more liquid phase epitaxially grown regions of high resistivity InP or $In_{1-x} Ga_x As_y P_{1-y}$ blocking material characterised in that the high resistivity material is doped with manganese together with a donor dopant or dopant mixture at a concentration providing partial compensation of the manganese doping.

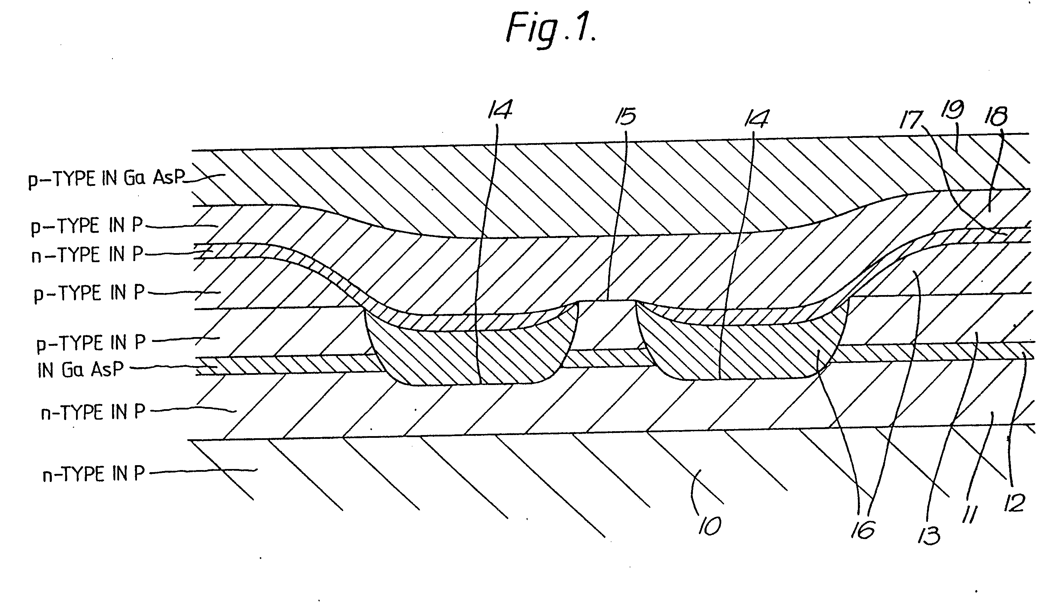

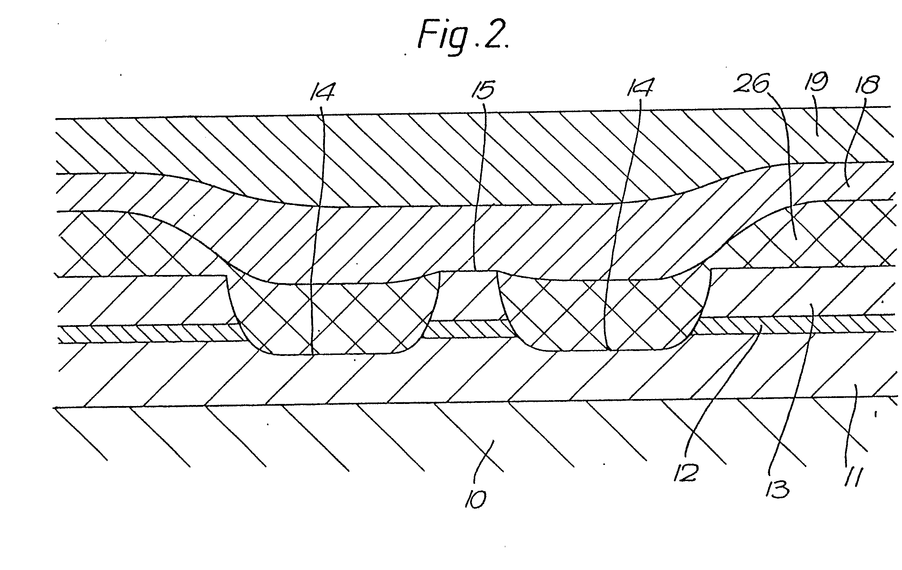

The level of the manganese acceptor ($E_n \approx$ 230meV) in InP is not as deep as that of iron, but its solubility is much greater, than thus it can be incorporated during liquid phase epitaxy at a temperature in the region of $650^\circ$ in sufficient concentration to dominate the electrical properties of the grown material. In the absence of any doping other than manganese, only a small proportion, typically 1 in $10^4$, of the acceptor levels are filled with electrons at room temperatures since exp $(-E_A/kT) \approx 10^{-4}$. This problem is overcome by partial compensation using a donor dopant or dopant mixture. Ideally this compensation should be as nearly complete as possible whilst ensuring that the acceptor concentration ($N_A$) exceeds the donor concentration ($N_D$). Typically, a safe margin is left by choosing $N_A \approx 2N_D$. Examples of suitable donor dopants include germanium, tin, sulphur selenium and tellurium. 0160403 There follows a description of an injection laser that includes in its construction high resistivity material made by the method of the present invention. This description refers to Figures 1 and 2 of the accompanying drawings depicting schematic cross-sections respectively through a double channel planar buried heterostructure (DCPBH) laser of the prior art, and through a laser including high resistivity material of the invention. Reference to this description may be prefaced by reference to a Table (page 5) setting out results of measurements made upon a number of high resistivity epitaxial layers grown by the method of the present invention when using germanium for partial compensation of the manganese doping. These all refer to a quaternary alloy $In_{1-x} Ga_x As_y P_{1-y}$ where y is about 0.09 and x is about 0.04.

Figure 1 depicts a prior art double-channel planar buried heterostructure laser whose structure has been described by I. Mito et al in Electronics Letters 28th October, 1982, Volume 18 No. 22 pp 953-4. Initially three layers 11, 12 and 13 are grown by liquid phase epitaxy upon an n-type InP substrate 10. These three layers comprise a quaternary InGaAsP active layer 12 sandwiched between an n-type InP buffer layer 11 and a p-type InP cladding layer 13 to form a double heterostructure. Two channels 14 are then etched through the active layer to define a stripe mesa 15. Then, in a second stage of liquid phase epitaxy, four further layers 16, 17, 18 and 19 are grown. The first of these layers is a reinstatement p-type InP layer 16 which partially fills the channels 14 and is grown under conditions which do not provide net growth of material on the top of the mesa. Growth is similarly restricted when the next layer, an n-type InP blocking layer 17, is grown. The function of this blocking layer is to provide a current confining reverse biassed p-n junction, namely that formed at the interface between it and the underlying p-type material of the reinstatement layer 16. The blocking layer 17 is covered by a p-type InP embedding layer 18, which is itself covered by a p-type InGaAsP layer 19 provided to facilitate the making of an ohmic contact (not shown).

In operation of the device the reverse biassed p-n junction serves to funnel the current flow into the mesa 15 where the majority of that current flow will pass through the active layer as desired. However, a portion of the current maybe able to bypass the active layer by flowing out through the sides of the mesa into the p-type material 16.

According to the teachings of the present invention the n-type InP blocking layer 17 is dispensed with entirely, and the p-type InP reinstatement layer is replaced by a high resistivity layer 26 as depicted in Figure 2. In principle this layer 26 may be of InP but, because we find that the crystal quality of InGaAsP close in composition to InP, such as $In_{0.96} As_{0.09} P_{0.91}$, grown by liquid phase epitaxy is better than that of InP, we generally prefer to make layer 26 of this quaternary material rather than the binary. With this arrangement current is constrained to flow through the active region because the alternative paths traverse high resistivity material (produced by doping with manganese and a partially compensating donor dopant such as germanium) and the forward biassed p-n junctions at the bottom of the channels, which are in higher band-gap material than the active junction.

## TABLE

| Dopant content of melt used for LPE growth at 615°C | | Electrical properties of epilayer at room temperature | |
|---|---|---|---|
| Mn ( g per gIn) | Ge (mg per gIn) | Free hole concentration $(cm^{-3})$ | Resistivity (ohm cm) |
| 8.45 | 0.70 | $2.2 \times 10^{16}$ | 2.1 |
| 8.45 | 1.25 | $2.0 \times 10^{16}$ | 2.3 |
| 8.45 | 2.42 | $1.8 \times 10^{16}$ | 2.6 |
| 8.45 | 4.81 | $1.6 \times 10^{16}$ | 2.9 |
| 8.45 | 9.62 | $1.3 \times 10^{16}$ | 3.6 |

CLAIMS :

1.      A method of semiconductor device manufacture including the step of growing high resistivity InP or $In_{1-x} Ga_x As_y P_{1-y}$ blocking material by liquid phase epitaxy, characterised in that the blocking material is doped with manganese together with a donor dopant or dopant mixture at a concentration providing partial compensation of the manganese doping.

2.      A method as claimed in claim 1, wherein the donor dopant concentration in said high resistivity material is approximately half the concentration of the manganese.

3.      A method as claimed in claim 1 or 2, wherein the donor dopant of the high resistivity material is germanium.

4.      A method as claimed in claim 1, 2 or 3, wherein the high resistivity material is grown in two channels defining a rib mesa in the course of the manufacture of a double channel planar buried heterostructure laser.

5.      A semiconductor device incorporating one or more liquid phase epitaxially grown regions of high resistivity InP or $In_{1-x} Ga_x As_y P_{1-y}$ blocking material characterised in that the high resistivity material is doped with manganese together with a donor dopant or dopant mixture at a concentration providing partial compensation of the manganese doping.

6.      A device as claimed in claim 5, wherein the donor dopant concentration of the high resistivity material is approximately half the concentration of the manganese.

7.      A device as claimed in claim 5 or 6, wherein the donor dopant of the high resistivity material is germanium.

8.      A device as claimed in claim 5, 6 or 7, wherein the high resistivity material forms a blocking layer in a laser structure.

9.      A laser as claimed in claim 8, wherein the high resistivity blocking material has been grown in two channels defining the rib mesa of a double channel planar buried heterostructure laser.

# Fig.1.

p-TYPE IN Ga AsP

p-TYPE IN P

n-TYPE IN P

p-TYPE IN P

p-TYPE IN P
IN Ga AsP

n-TYPE IN P

n-TYPE IN P

14  15  14  17  19  18

1/2

16  13  11  12

10

0160403

Fig. 2.

212

0160403